# FASCICULE DE BREVET EUROPEEN

(11) **EP 4 133 317 B1**
(45) Date de publication et mention de la délivrance du brevet: **05.06.2024**
(21) Numéro de dépôt: 21716431.8
(22) Date de dépôt: 06.04.2021
(51) Int. Cl.: G02B 6/132

(54) **PROCÉDÉ DE FABRICATION D'UNE COUCHE MIXTE COMPORTANT UN GUIDE D'ONDE EN SILICIUM ET UN GUIDE D'ONDE EN NITRURE DE SILICIUM**
VERFAHREN ZUR HERSTELLUNG EINER MISCHSCHICHT MIT EINEM SILIZIUMWELLENLEITER UND EINEM SILIZIUMNITRIDWELLENLEITER
METHOD FOR MANUFACTURING A MIXED LAYER COMPRISING A SILICON WAVEGUIDE AND A SILICON NITRIDE WAVEGUIDE

(30) Priorité: 10.04.2020 FR 2003653
(43) Date de publication de la demande: 15.02.2023
(73) Titulaire: Commissariat à l'Energie Atomique et aux Energies Alternatives, 75015 Paris (FR); THALES, 92400 Courbevoie (FR)
(72) Inventeur: MALHOUITRE, Stéphane, 38054 GRENOBLE Cedex 09 (FR); BITAULD, David, 91300 MASSY (FR); HASSAN, Karim, 38054 GRENOBLE Cedex 09 (FR); RAMIREZ, Joan, 91440 BURES-SUR-YVETTE (FR); SHEN, Alexandre, 91400 ORSAY (FR)
(74) Mandataire: INNOV-GROUP
(86) Numéro de dépôt international: PCT/EP2021/058847
(87) Numéro de publication internationale: WO 2021/204749

(56) Documents cités:
- CN-A- 110 954 998
- US-A1- 2016 197 111
- US-B1- 9 671 557
- US-B2- 10 270 222

## Description

L'invention concerne un procédé de fabrication d'une couche mixte comportant un premier guide d'onde dont le coeur est en silicium et un second guide d'onde dont le coeur est en nitrure de silicium. L'invention concerne également :
- un procédé de fabrication d'un composant photonique en utilisant ce procédé de fabrication d'une couche mixte, et
- le composant photonique ainsi fabriqué.

Comme décrit dans le brevet US10270222B1 et dans la demande WO2019002763A1, par exemple dans le contexte particulier d'une source laser à semi-conducteur, il est avantageux d'utiliser un guide d'onde en matériau à gain III-V et des guides d'onde en silicium et en nitrure de silicium. En effet, cela permet d'améliorer les performances et les propriétés de la source laser. On note que plus largement les composants photoniques à semi-conducteurs III-V peuvent bénéficier de performances améliorés lorsqu'ils sont associés avec des guides d'ondes en silicium et en nitrure de silicium.

Par la suite, les expressions « guide d'onde en silicium » et « guide d'onde en nitrure de silicium » désignent des guides d'onde dont les coeurs sont réalisés, respectivement, en silicium et en nitrure de silicium.

Dans les procédés connus de fabrication de tels composants photoniques, les trois guides d'onde différents sont réalisés dans des couches respectives empilées les unes au-dessus des autres. Ainsi, pour fabriquer ces composants photoniques, il faut fabriquer un empilement d'au moins trois couches différentes.

La fabrication de ces composants photoniques serait donc simplifiée et leur densité d'intégration serait améliorée s'il était possible de réaliser une couche mixte contenant, dans un même niveau, les guides d'onde en silicium et les guides d'onde en nitrure de silicium.

Toutefois, un procédé efficace et simple de fabrication d'une telle couche mixte n'existe pas. Cela vient notamment du fait que, à ce jour, il n'existe pas de procédé simple de polissage mécano-chimique d'une couche épaisse de nitrure de silicium recouvrant la majorité de la face extérieure d'un substrat et qui, en plus, peut être arrêté dès qu'une couche sous-jacente, par exemple en oxyde de silicium, est mise à jour.

De l'arrière plan technologique est connu de CN110954998A, US9671557B1 et US2016/197111A1.

L'invention vise donc à pallier ce manque. Elle a donc pour objet un procédé de fabrication d'une couche mixte conforme à la revendication 1.

L'invention a également pour objet un procédé de fabrication d'un composant photonique à semi-conducteur III-V en mettant en oeuvre le procédé ci-dessus de fabrication d'une couche mixte.

Enfin, l'invention a également pour objet un composant photonique à semi-conducteur III-V fabriqué par le procédé ci-dessus.

L'invention sera mieux comprise à la lecture de la description qui va suivre, donnée uniquement à titre d'exemple non limitatif et faite en se référant aux dessins sur lesquels :
- la figure 1 est une illustration schématique de l'architecture d'une source laser à semi-conducteur ;
- la figure 2 est une illustration schématique, en vue de dessus, d'un exemple de filtre pouvant être mis en oeuvre dans la source laser de la figure 1 ;
- la figure 3 est une illustration schématique, en coupe verticale, d'un mode de réalisation possible de la source laser de la figure 1 ;
- la figure 4 est une illustration schématique, en vue de dessus, de couplages optiques entre différents guides d'onde de la source laser de la figure 3 ;
- les figures 5 à 10 sont des illustrations schématiques, selon différents plans de coupe transversale, des couplages optiques de la figure 4 ;
- la figure 11 est un organigramme d'un procédé de fabrication de la source laser de la figure 3 ;
- les figures 12 à 26 sont des illustrations schématiques, en coupe verticale, de différents états de fabrication obtenus lorsque le procédé de la figure 11 est mis en oeuvre ;
- la figure 27 est un organigramme d'un procédé de fabrication d'une couche mixte susceptible d'être mise en oeuvre pour réaliser la source laser de la figure 3 ;
- les figures 28 et 29 sont des représentations schématiques, en coupe verticale, de deux états de fabrication obtenus lorsque le procédé de la figure 27 est mis en oeuvre ;
- la figure 30 est un organigramme d'un autre procédé de fabrication d'une couche mixte susceptible d'être mise en oeuvre pour fabriquer la source laser de la figure 3 ;
- les figures 31 à 33 sont des illustrations schématiques, en coupe verticale, de différents états de fabrication obtenus lorsque le procédé de la figure 30 est mis en oeuvre ;
- la figure 34 est une illustration schématique, en vue de dessus, d'un autre mode de réalisation d'un coupleur optique entre un guide d'onde en silicium et un guide d'onde en nitrure de silicium ;
- la figure 35 est une illustration schématique, en coupe verticale, du coupleur optique de la figure 34.

Dans ces figures, les mêmes références sont utilisées pour désigner les mêmes éléments. Dans la suite de cette description, les caractéristiques et fonctions bien connues de l'homme du métier ne sont pas décrites en détail.

Par la suite, les définitions de certains termes et expressions utilisées dans cette demande sont données dans un chapitre I. Ensuite, des exemples détaillés de modes de réalisation sont décrits dans un chapitre Il en référence aux figures. Dans le chapitre III suivant, des variantes de ces modes de réalisation sont présentées. Enfin, les avantages des différents modes de réalisation sont présentés dans un chapitre IV.

### Chapitre I : Terminologie et définitions

Dans cette description, lorsque l'on indique qu'un guide d'onde est réalisé en matériau X, cela signifie que le coeur de ce guide d'onde est réalisé dans ce matériau X. La gaine de ce guide d'onde est réalisée dans un autre matériau d'indice de réfraction plus faible.

Lorsqu'on indique qu'un élément "est réalisé en matériau X", cela signifie que le matériau X représente plus de 90% ou 95% ou 98%, en masse, du poids de cet élément.

L'indice effectif n_{eff} de propagation est aussi connu sous le nom de « constante de phase du mode ». Il est défini par la relation suivante : n_{g} = n_{eff} - λdn_{eff}/dλ, où n_{g} est l'indice de groupe et À est la longueur d'onde du signal optique guidé par le guide. L'indice effectif de propagation d'un guide d'onde dépend des dimensions du coeur de ce guide d'onde et des matériaux formant ce coeur et la gaine de ce guide d'onde. Il peut être déterminé expérimentalement ou par simulation numérique.

La gaine d'un guide d'onde est généralement réalisée en matériau diélectrique. Dans ce cas le matériau diélectrique est un matériau diélectrique dont l'indice n_{md} de réfraction est plus petit que l'indices n_{Si} si le coeur du guide d'onde est en silicium et que l'indice n_{SiN} si le coeur est en nitrure de silicium, où n_{Si} et n_{SiN} sont les indices de réfraction, respectivement, du silicium et du nitrure de silicium. Typiquement, l'indice n_{md} est inférieur ou égal à 0,85 x n_{c} ou inférieur ou égal à 0,75 x n_{c}, où n_{c} est l'indice de réfraction du coeur du guide d'onde.

Par "dissoudre" on désigne l'action d'une opération de gravure d'un matériau par une gravure humide ou sèche.

### Chapitre II : Exemples de modes de réalisation

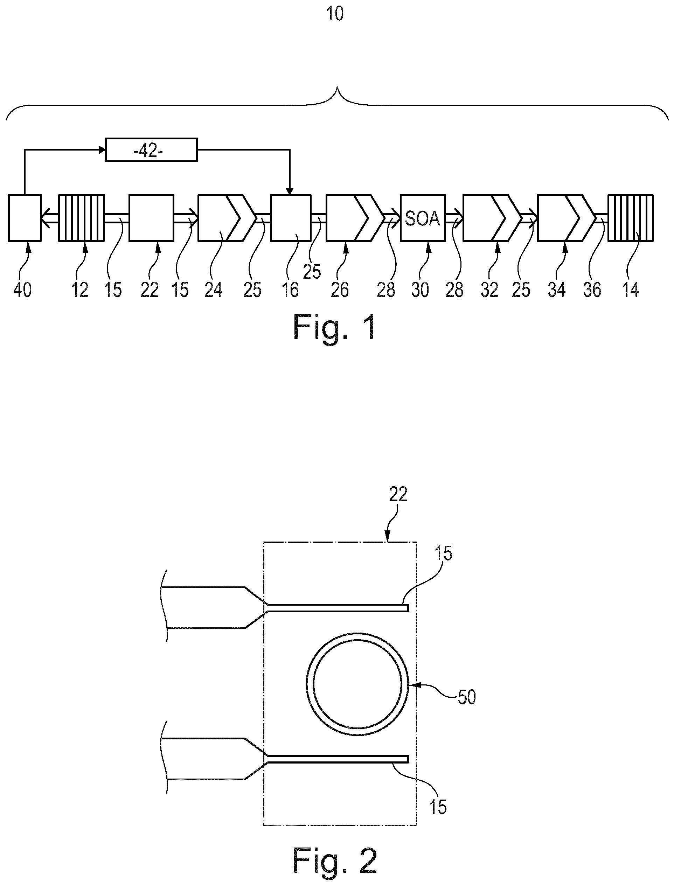

La figure 1 représente schématiquement l'architecture générale d'une source laser 10 à semi-conducteur monochromatique qui émet à la longueur d'onde λ_{Li}. Par la suite, seules les particularités de la source laser 10 sont décrites en détail. Pour des informations générales sur le fonctionnement d'une source laser à semi-conducteur utilisant des guides d'onde en silicium, en nitrure de silicium et en matériau à gain III-V, le lecteur peut consulter le brevet US10270222B1 et la demande WO2019002763A1. Comme cela apparaîtra à la lecture de la suite de la description, la source laser 10 se distingue des sources lasers connues principalement par l'agencement de ses guides d'ondes en silicium et en nitrure de silicium.

La source laser 10 comporte un réflecteur arrière 12 et un réflecteur avant 14 qui définissent les extrémités d'une cavité de Fabry-Pérot à l'intérieur de laquelle le signal optique résonne. Par exemple, le réflecteur 12 présente un facteur de réflexion strictement supérieur à celui du réflecteur 14. Les réflecteurs 12 et 14 sont, par exemple, des réflecteurs large bande. Ici, les réflecteurs 12 et 14 sont des réflecteurs tels que des réseaux de Bragg.

Entre les réflecteurs 12 et 14, la source laser comporte successivement les composants photoniques suivants en allant du réflecteur 12 vers le réflecteur 14 :
- un guide d'onde optique 15 en nitrure de silicium (Si₃N₄) dans lequel est réalisé le réflecteur 12,
- un filtre passe-bande 22 apte à sélectionner la longueur d'onde λ_{Li} de fonctionnement de la source laser 10 parmi différentes longueurs d'onde λ_{Rj} possibles à l'intérieur de la cavité de Fabry-Pérot, ce filtre 22 étant réalisé dans le guide d'onde 15 en nitrure de silicium,
- un coupleur 24 en pointe inversée ("inverse taper" en anglais) qui raccorde optiquement une première région du guide d'onde 15 à une première région d'un guide d'onde 25 en silicium,
- le guide d'onde 25 en silicium,
- un dispositif d'accord 16 optionnel réalisé dans le guide d'onde 25, ce dispositif d'accord 16 étant apte à déplacer les longueurs d'onde λ_{Rj} en fonction d'un signal électrique de commande et en utilisant les propriétés du silicium du guide d'onde 25,
- un coupleur adiabatique ou évanescent 26 qui raccorde optiquement une deuxième région du guide d'onde 25 à une première région en vis-à-vis d'un guide d'onde 28 en matériau à gain III-V,
- un amplificateur optique 30 à semi-conducteur plus connu sous l'acronyme SOA (« Semiconductor Optical Amplifier ») réalisé dans le guide d'onde 28 et apte à générer et à amplifier le signal optique résonant à l'intérieur de la cavité de Fabry-Pérot à chaque longueur d'onde λ_{Rj},
- un coupleur adiabatique ou évanescent 32 qui raccorde optiquement une deuxième région du guide d'onde 28 à une troisième région en vis-à-vis du guide d'onde 25,
- un coupleur 34 en pointe inversée qui raccorde optiquement une quatrième région du guide d'onde 25 à une première région d'un guide d'onde 36 en nitrure de silicium (Si₃N₄), et
- le réflecteur 14 réalisé dans l'extrémité guide 36.

Pour une description détaillée d'un coupleur adiabatique, le lecteur est renvoyé à l'article suivant : Amnon Yariv et al., « Supermode Si/III-V hybrid Lasers, optical amplifiers and modulators: proposal and analysis » Optics Express 9147, vol. 14, No. 15, 23/07/2007.

En particulier, un coupleur adiabatique est apte à transférer la quasi-totalité du signal optique présent dans un premier guide d'onde vers un second guide d'onde situé au-dessus ou en dessous, sans réflexion. Un tel coupleur adiabatique est, par exemple, obtenu en modifiant la largeur du premier guide d'onde par rapport à la largeur du second guide d'onde. Typiquement pour un couplage adiabatique d'un guide d'onde en silicium vers un guide d'onde en matériau III-V, la largeur du guide d'onde en silicium est progressivement réduite à l'approche du guide d'onde en matériau III-V. En sens inverse, pour transférer par couplage adiabatique un signal optique du guide d'onde en matériau III-V vers le premier guide d'onde en silicium, la largeur du guide d'onde en silicium est par exemple progressivement augmentée. De plus, les guides d'onde en silicium et en matériau III-V ont généralement une largeur telle qu'il existe des zones de ces guides d'onde en vis-à-vis où leurs indices effectifs respectifs de propagation sont égaux.

Dans ce mode de réalisation, le filtre 22 est un filtre en anneau résonant dont l'anneau est réalisé dans un guide d'onde 50 (figure 2) en Si₃N₄. De préférence, le guide d'onde 50 dans lequel est réalisé l'anneau est directement raccordé optiquement à deux extrémités du guide d'onde 15 par couplage évanescent. Un couplage évanescent est obtenu en rapprochant les deux guides d'onde l'un de l'autre. Ici, le filtre 22 est identique à celui décrit dans le brevet US10270222B1 et dans la demande WO2019002763A1.

Pour générer le signal électrique de commande du dispositif d'accord 16, la source laser 10 comporte également un capteur 40 et un circuit électronique 42 apte à générer le signal électrique de commande du dispositif d'accord 16 de manière à maintenir en permanence une longueur d'onde λ_{Rj} au centre de la bande passante du filtre 22. Le capteur 40 et le circuit 42 sont, par exemple, identiques à ceux décrits dans le brevet US10270222B1 et la demande WO2019002763A1.

La lumière qui ressort par l'intermédiaire des réflecteurs 12 et 14 est ensuite guidée, par exemple, vers une photodiode ou une fibre optique. Pour cela des composants optiques supplémentaires sont utilisés. Étant donné que ces composants optiques supplémentaires sont conventionnels, ils ne sont pas décrits ici en détail et, pour simplifier les figures, ils ne sont pas non plus représentés.

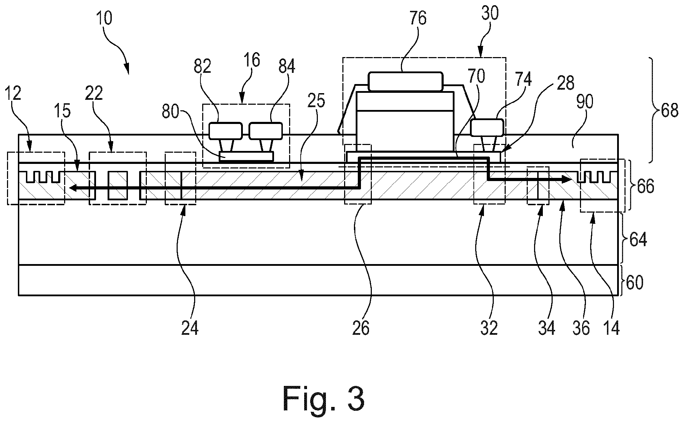

La figure 3 représente un premier mode de réalisation de la source laser 10. Ici, la source laser 10 est fabriquée sur un substrat 60 en silicium, par exemple cristallin, qui s'étend principalement dans un plan horizontal correspondant au plan du substrat.

Sur la figure 3, la source laser 10 comporte successivement empilées au-dessus du substrat 60 en allant du bas vers le haut :
- une couche 64 en matériau diélectrique enterré,
- une couche mixte 66 qui contient les guide d'onde 15 et 36 en nitrure de silicium et le guide d'onde 25 en silicium, et
- une couche 68 en matériau III-V encapsulé comportant le guide d'onde 28 à l'intérieur duquel est réalisé l'amplificateur 30 dans cet exemple de mode de réalisation.

L'épaisseur du substrat 60 est importante, c'est-à-dire supérieure à 100 µm ou 300 µm.

Le matériau diélectrique de la couche 64 est typiquement un oxyde. Ici, l'oxyde enterré est de l'oxyde de silicium, d'une épaisseur supérieure à 720nm, et de préférence supérieure à 1.5µm. Ici, l'épaisseur de la couche 64 est égale à 2µm.

Les coupleurs adiabatiques 26 et 32 sont réalisés en partie dans le guide d'onde 25 et dans le guide d'onde 28.

L'amplificateur 30 est par exemple identique à l'amplificateur décrit dans le brevet US10270222B1 et la demande WO2019002763A1. Dans ce cas, le guide d'onde 28 et l'amplificateur 30 se présentent sous la forme d'un empilement de sous-couches en alternance de puits et de barrières en matériaux ternaires et/ou quaternaires. Par exemple, dans le cas d'une épitaxie sur substrat InP il s'agit d'une alternance de quaternaire InGaAsP ou AlGaInAs avec deux bandes interdites ("bandgap" en anglais) distinctes pour puits et barrières. Dans le cas d'une épitaxie sur substrat GaAs, il s'agit d'une alternance de matériaux GalnNAs avec deux bandes interdites distinctes pour puits et barrières ou une alternance de GalnNAs et GaNAs. Ces alternances de puits et barrières sont interposées entre une sous-couche inférieure 70 et une sous-couche supérieure dopé P en InP ou GaAs respectivement. La sous-couche 70 est une sous-couche en matériau III-V de dopage opposé à la sous couche supérieure. Par exemple, ici, il s'agit d'une sous-couche dopé N en InP ou GaAs respectivement. L'amplificateur 30 comporte une prise 74 directement en contact mécanique et électrique avec la sous-couche 70. La sous-couche en dopée P (InP ou GaAs) est en contact mécanique et électrique avec une prise 76. Lorsqu'un courant supérieur au courant de seuil de la source laser est appliqué entre les prises 74 et 76, l'amplificateur 30 génère et amplifie le signal optique qui résonne à l'intérieur de la cavité de Fabry-Pérot.

Le dispositif d'accord 16 est ici une chaufferette apte à chauffer le guide d'onde 25 pour déplacer les longueurs d'onde λ_{RJ}. Dans ce mode de réalisation, le dispositif d'accord 16 comprend une résistance 80 électriquement raccordée à deux prises 82 et 84 de contact électrique. Typiquement, la résistance 80 est séparée du guide d'onde 25 par une distance supérieure à 500 nm ou 600 nm. Ces prises 82 et 84 sont électriquement raccordées à une source de courant ou de tension commandée par le circuit électronique 42 en fonction des mesures du capteur 40.

Le dispositif d'accord 16, le guide d'onde 28 et l'amplificateur 30 sont recouverts d'une enveloppe protectrice 90 qui les isole mécaniquement de l'extérieur. Seules les prises 74, 76, 82, 84 font saillie au-delà de l'enveloppe 90. Par exemple, l'enveloppe 90 est réalisée en nitrure de silicium ou en oxyde de silicium ou en BenzoCycloButène (BCB).

Le trajet du signal optique résonant dans la source laser 10 est représenté sur la figure 3 par une double flèche en gras.

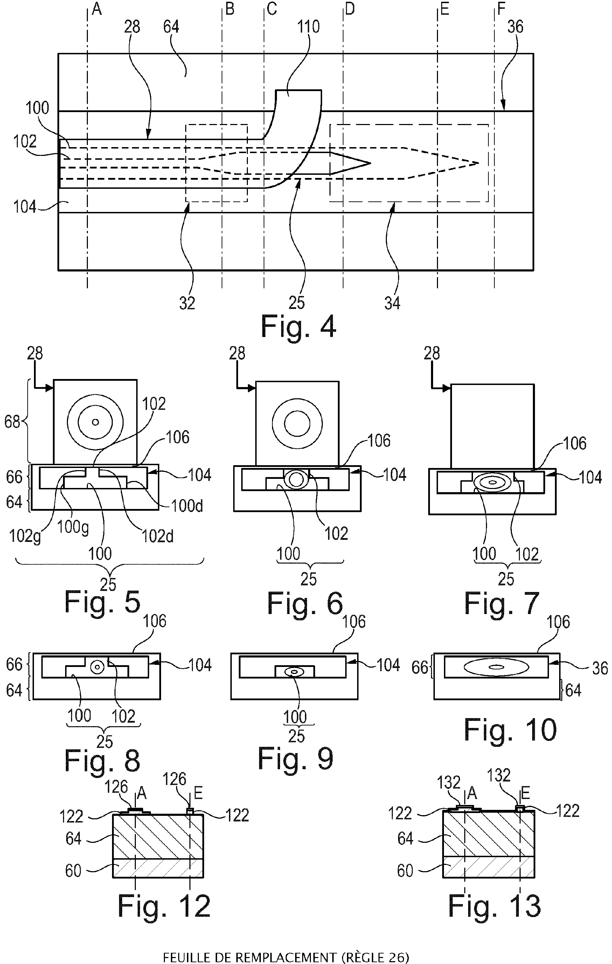

Les figures 4 à 10 représentent le couplage adiabatique 32 et le couplage 34 en pointe inversée. Les couplages 26 et 24 sont, par exemple, réalisés de la même façon que, respectivement, les couplages 32 et 34.

La figure 4 représente en vue de dessus une portion des guides d'onde 28, 25 et 36. Sur cette figure 4, seul le coeur des guides 25, 28 et 36 et la couche 64 sur laquelle reposent ces coeurs sont représentés. Les gaines des guides 25, 28 et 36 ne sont pas représentées. Les limites du coeur du guide 25 sont représentées en lignes pointillées lorsqu'elles sont cachées par le guide 28 ou 36.

Sur les figures 5 à 10, la gaine du guide 28 et le substrat 60 ne sont pas représentés.

Sur la figure 4, les traits en pointillés A à F représentent les positions, respectivement, de sections transversales A à F. Les sections transversales A à F sont représentées, respectivement, sur les figures 5 à 10. Plus précisément, en allant de la gauche vers la droite :
- la section transversale A se situe sous le guide 28 et entre les coupleurs 26 et 32,
- la section transversale B se situe sensiblement au milieu du coupleur 32,
- la section transversale C se situe entre les coupleurs 32 et 34,
- la section transversale D se situe au début du coupleur 34,
- la section transversale E se situe à la fin du coupleur 34, et
- la section transversale F se situe entre les coupleurs 34 et le réflecteur 14.

Dans ce mode de réalisation, le coeur en silicium du guide 25 comporte une bande horizontale 100 et une arête 102 superposée sur cette bande 100. Une telle conformation du guide 25 est appelée « guide d'onde en arête » (« rib waveguide » en anglais). Cette conformation en arête est représentée sur les figures 5 à 8.

La section transversale de la bande 100 est rectangulaire. La bande 100 comporte donc une face inférieure horizontale directement en contact avec la face supérieure de la couche 64 et, du côté opposé, une face supérieure horizontale. Elle comporte aussi des flancs latéraux 100g et 100d (Figure 5). Les flancs 100g et 100d s'étendent verticalement.

La section transversale de l'arête 102 est aussi rectangulaire. Elle comporte une face inférieure horizontale qui affleure la face supérieure de la bande 100 et, du côté opposé, une face supérieure horizontale. Elle a aussi des flancs latéraux 102g et 102d (Figure 5) qui s'étendent verticalement.

Dans ce mode de réalisation, les flancs latéraux 100g, 100d, 102g et 102d et la face supérieure de l'arête 102 sont encapsulés dans un bloc 104 en nitrure de silicium. Ce bloc 104 recouvre complètement les flancs latéraux 100g, 100d, 102g, 102d et la face supérieure de l'arête 102 aux emplacements des sections transversales A à D. Ainsi, la gaine du guide d'onde 25 est ici réalisée en nitrure de silicium au moins le long de ses flancs latéraux et de sa face supérieure. Sur les figures 5 à 8, la fine épaisseur de nitrure de silicium qui recouvre la face supérieure du guide 25 n'est pas visible. Le bloc 104 est séparé du guide d'onde 28 par une fine couche 106 en matériau diélectrique. Ainsi, le guide d'onde 28 est séparé du guide d'onde 25 par la couche 106 et par le nitrure de silicium qui recouvre la face supérieure du guide 25.

Au niveau du coupleur 32 (figure 6), la section transversale de l'arête 102 s'évase progressivement en allant de la gauche vers la droite de manière à former des zones en vis-à-vis dans les guides d'onde 25 et 28 dont les indices effectifs de propagation sont égaux. Dans ce mode de réalisation, au niveau du coupleur 32, la section transversale de la bande 100 reste constante.

Ensuite, entre les coupleurs 32 et 34, la section transversale du guide d'onde 25 reste constante (Figure 7 : section transversale C).

Dans ce mode de réalisation, le guide d'onde 28 se termine par une zone 110 d'absorption. Cette zone 110 est située après le coupleur 32 et conformée pour évacuer la fraction résiduelle du signal optique qui n'a pas été transférée, par le coupleur 32, dans le guide d'onde 25.

En allant de la gauche vers la droite, au début du coupleur 34, la section transversale de l'arête 102 (Figure 8 : section D) se rétrécit progressivement jusqu'à disparaître. Pour cela, les flancs latéraux 102g et 102d se rapprochent progressivement l'un de l'autre jusqu'à une extrémité de l'arête 102 au-delà de laquelle cette arête 102 n'existe plus. Ce rétrécissement de la section transversale de l'arête 102 forme une première terminaison en pointe. Au-delà de cette extrémité de l'arête 102, le signal optique est donc essentiellement confiné à l'intérieur de la bande 100. Ici, du début du coupleur 34 jusqu'à l'extrémité de l'arête 102, la section transversale de la bande 100 reste constante.

Ensuite, au-delà de l'extrémité de l'arête 102, la section transversale de la bande 100 se rétrécit progressivement, en allant de la gauche vers la droite, jusqu'à disparaître (Figure 9 : section E). Pour cela, comme pour l'arête 102, les flancs latéraux 100g et 100d se rapprochent progressivement l'un de l'autre jusqu'à une extrémité de la bande 100 au-delà de laquelle le guide d'onde 25 n'existe plus et à partir de laquelle débute le guide 36. Ce rétrécissement de la section transversale de la bande 100 forme une seconde terminaison en pointe. Ainsi, le guide 36 (Figure 10 : section F) se situe dans la même couche 66 que le guide d'onde 25 et dans le prolongement du guide d'onde 25.

La section transversale du guide d'onde 36 est ici rectangulaire. Elle présente donc une face inférieure horizontale directement en appui mécanique sur la face supérieure de la couche 64 et, du côté opposé, une face supérieure horizontale. Ce guide d'onde 36 se situe donc au même niveau que le guide d'onde 25. En effet, les faces inférieures horizontales des guides d'onde 25 et 36 sont situées dans le même plan horizontal.

Au-delà de l'extrémité de la bande 100, l'essentiel du signal optique a été transféré du guide d'onde 25 vers le guide d'onde 36.

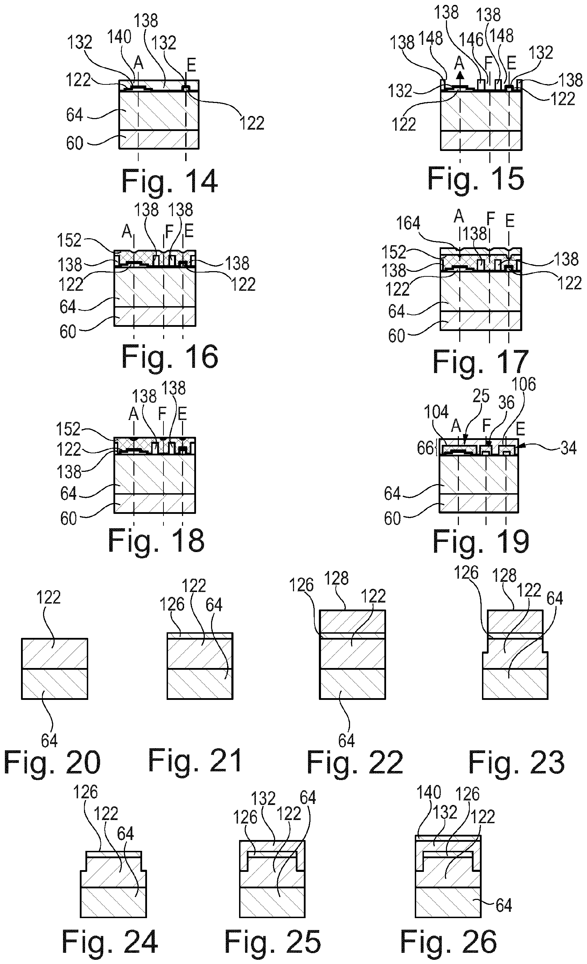

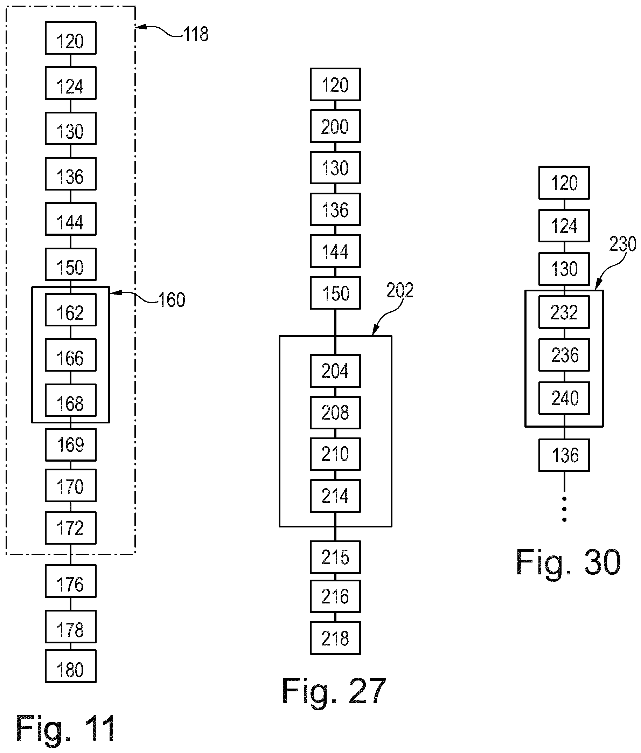

Un procédé de fabrication de la source laser 10 va maintenant être décrit à l'aide des figures 11 à 26. Sur les figures 20 à 26, le substrat 60 n'est pas représenté.

Sur les figures 12 à 19, seuls les états de fabrication de la source laser aux emplacements des sections transversales E, F et A sont représentés. Sur ces figures, les emplacements de ces sections transversales A, E et F sont représentés par des traits verticaux en pointillés portant les références numériques, respectivement, A, E et F. Sur les figures 12 à 19, à titre d'illustration, ces sections transversales sont représentées comme étant l'une à côté de l'autre. Toutefois, dans la réalité, elles sont situées l'une derrière l'autre dans la direction de propagation du signal optique le long des guides d'onde 25 et 36 comme représenté, par exemple, sur la figure 4.

Le procédé débute par une phase 118 de fabrication de la couche mixte 66 sur la couche 64. Cette phase 118 débute par une étape 120 de fourniture d'un empilement comportant, immédiatement empilés les uns sur les autres, le substrat 60, la couche 64 d'oxyde enterrée et une couche 122 (figure 20) de silicium monocristallin. Un tel empilement est connu sous l'acronyme SOI (« Silicon On Insulator »). L'épaisseur de la couche 64 est généralement supérieure à 1 µm. Par exemple, ici, l'épaisseur de la couche 64 est égale à 2 µm ou 3 µm. L'épaisseur de la couche 122 est plus petite et, généralement, inférieure à 1µm. Par exemple, dans ce mode de réalisation, l'épaisseur de la couche 122 est égale à 500 nm.

Lors d'une étape 124, la couche 122 est structurée pour réaliser le coeur en silicium du guide d'onde 25. Par exemple, lors de cette étape, des opérations de photolithographie, de gravure et de retrait de masque en résine sont mises en oeuvre. En particulier, étant donné la conformation du guide d'onde 25, des opérations de gravure partielle sont mises en oeuvre pour amincir la couche 122 de silicium et laisser subsister par endroits seulement une épaisseur de 300 nm ou de 150 nm de silicium monocristallin. Ensuite, généralement, une opération de gravure totale de la couche 122 permet de séparer les différents composants photoniques réalisés en silicium monocristallin à partir de cette couche 122.

Plus précisément, comme illustré plus en détail sur les figures 21 à 24, typiquement, lors de l'étape 124, une sous-couche 126 (Figure 21) d'oxyde de silicium est déposée sur le sommet du guide d'onde 25. Sur les figures 21 à 26, seule une portion du guide d'onde 25 dont l'épaisseur est égale à 500 nm est représentée. Ici, l'épaisseur de la sous-couche 126 est par exemple égale à 20 nm. Ensuite, un masque 128 (figures 22 et 23), par exemple réalisé en nitrure de silicium dur ou en résine, est déposé au-dessus des zones de la couche 122 qui ne doivent pas être gravées. Enfin, après les opérations de gravure, le masque 128 est retiré (figure 24). On obtient alors l'état représenté sur la figure 12.

Lors d'une étape 130, un fin revêtement 132 (Figures 13 et 25) d'arrêt de gravure est déposé sur toute la face supérieure. Ici, le revêtement 132 est en nitrure de silicium. L'épaisseur du revêtement 132 est typiquement comprise entre 20 nm et 100 nm ou entre 20 nm et 50 nm. Ce revêtement 130 recouvre en particulier la face supérieure de la couche 64 mise à nu par la gravure totale réalisée lors de l'étape 124. Il recouvre également la face supérieure du coeur du guide d'onde 25. Un tel revêtement est connu sous le terme anglais de « liner ». L'état obtenu après le dépôt du revêtement 132 est représenté sur les figures 13 et 25. Pour simplifier les figures 13 à 19, les portions résiduelles de la sous-couche 126 d'oxyde qui se trouve sous le revêtement 132 n'ont pas été représentées sur ces figures.

Par exemple, le revêtement 132 est déposé par un dépôt chimique en phase vapeur assisté par plasma, c'est-à-dire par un procédé connu sous l'acronyme PECVD (« Plasma Enhanced Chemical Vapor Deposition »).

Ensuite, une étape 136 d'encapsulation du coeur en silicium puis de planarisation est réalisée. Lors de l'étape 136, un matériau diélectrique 138 (Figure 14) est déposé pour encapsuler le coeur en silicium. Ici, ce matériau diélectrique est de l'oxyde de silicium. A titre d'illustration, il s'agit d'un oxyde de silicium de type HDP (« high density plasma »), ou bien un oxyde de silicium à base de TEOS (« Tetraethylorthosilicate »). L'épaisseur déposée de ce matériau diélectrique est supérieure à l'épaisseur maximale du coeur en silicium structuré lors des étapes précédentes. Typiquement cette épaisseur est plus d'1,5 fois supérieure à l'épaisseur maximale du coeur en silicium. De plus, cette épaisseur peut être augmentée en fonction de l'épaisseur de matériau diélectrique que l'on souhaite obtenir au-dessus du coeur en silicium.

Ensuite, la face supérieure est planarisée en mettant en oeuvre un polissage mécano-chimique plus connu sous l'acronyme CMP (« Chemical Mechanical Planarization »). Cette opération de planarisation est arrêtée lorsque le revêtement 132 situé au-dessus des portions du guide d'onde 25 dont l'épaisseur est égale à 500 nm sont mises à nu. Pour cela, typiquement, l'agent de gravure utilisé lors de cette opération de polissage mécano-chimique est un agent de gravure sélectif qui dissout au moins deux ou quatre fois plus rapidement le matériau diélectrique 138 que le nitrure de silicium.

Après cette opération de polissage mécano-chimique, la face supérieure est plane. Ici, à ce stade, une nouvelle sous-couche 140 (figures 14 et 26) d'oxyde de silicium est déposée afin d'obtenir une face supérieure entièrement en oxyde de silicium. L'épaisseur de la sous-couche 140 est choisie de manière à ajuster l'épaisseur du coeur en nitrure de silicium du guide d'onde 36 et et l'épaisseur du bloc 104. Par exemple, ici, l'épaisseur de la sous-couche 140 est choisie égale à 40 nm. A l'issue de l'étape 136, la couche de silicium encapsulé représenté sur la figure 14 est obtenue.

Ensuite, lors d'une étape 144, il est procédé à la réalisation d'une tranchée 146 (Figure 15) à l'emplacement où doit être réalisé le coeur en nitrure de silicium du guide 36. De plus, dans ce mode de réalisation, cette tranchée comporte un prolongement 148 (Figure 15) le long du coeur du guide d'onde 25 à l'emplacement où doit être formé le bloc 104 en nitrure de silicium. A cet effet, ce prolongement 148 met à nu les flancs latéraux du coeur du guide d'onde 25.

Par exemple, la tranchée 146 et son prolongement 148 sont réalisés par gravure sèche, à travers un masque, de la sous-couche 140 et du matériau 138. La gravure sèche est arrêtée lorsque le revêtement 132, situé à l'emplacement de la tranchée 146 est mis à nu. Pour cela, typiquement, l'agent de gravure utilisé est un agent de gravure sélectif qui dissout deux ou quatre fois plus rapidement l'oxyde de silicium que le nitrure de silicium.

Lors d'une étape 150, une couche 152 (figure 16) de nitrure de silicium est déposée sur toute la face extérieure. L'épaisseur de la couche 152 est suffisante pour remplir complètement la tranchée 146 et son prolongement 148. Par exemple, ici, l'épaisseur de la couche 152 est supérieure à 600 nm. Par exemple, la couche 152 est déposée par le procédé PECVD.

Lors d'une étape 160, les portions de la couche 152 déposée en dehors de la tranchée 146 et de son prolongement 148 sont retirées. Pour cela, dans ce mode de réalisation, lors d'une opération 162, une couche 164 (figure 17) d'oxyde de silicium est déposée sur toute la face supérieure de la couche 152. L'épaisseur de la couche 164 est suffisante pour reboucher complètement les creux formés dans la couche 152 à l'aplomb de la tranchée 146 et de son prolongement 148. Par exemple, l'épaisseur de la couche 164 est supérieure à 100 nm ou 150 nm.

Ensuite, lors d'une opération 166, la couche 164 est planarisée par polissage mécano-chimique. Ici, le polissage est arrêté lorsque la face supérieure de la couche 152 est atteinte. Par exemple, l'opération 166 est réalisée comme l'opération de planarisation décrite en référence à l'étape 136. A l'issue de cette opération, on obtient une face extérieure essentiellement constituée de nitrure de silicium et d'un peu d'oxyde de silicium à l'aplomb de la tranchée 146 et du prolongement 148. On obtient alors l'état représenté sur la figure 18. Sur la figure 18, les points noirs à l'aplomb de la tranchée 146 et de son prolongement 148 représentent les résidus d'oxyde de silicium à l'aplomb de ces éléments.

Puis, une opération 168 de gravure non sélective est exécutée. Lors de l'opération 168, l'agent de gravure utilisé dissout aussi rapidement l'oxyde de silicium que le nitrure de silicium. Dans ce texte par "dissout aussi rapidement l'élément A que l'élément B", on désigne le fait que la vitesse de gravure de l'élément B est comprise entre 0,8v_{A} et 1,2v_{A} et, de préférence, entre 0,9v_{A} et 1,1v_{A}, où v_{A} est la vitesse de gravure de l'élément A. L'opération 168 est arrêtée quand l'oxyde de silicium situé sous la couche 152 est atteint. Pour cela, la fin de cette gravure non sélective est détectée par détection d'espèce. La détection par "détection d'espèce" est plus connue sous l'expression anglaise de « optical émission spectroscopy ». Ce procédé permet d'identifier le matériau présent sur la face extérieure en cours de gravure. Dès que le matériau identifié est le matériau diélectrique sous la couche 152, la gravure non sélective est arrêtée. Toutefois, dans la pratique, une faible épaisseur, de l'ordre de 20 nm, de matériau diélectrique situé sous la couche 152 est quand même consommée. La gravure non sélective appliquée sur la face planarisée de la couche 164 permet de conserver la planéité de départ. Ainsi, à l'issue de l'opération 168, une face extérieure plane sur laquelle affleure les faces supérieurs du bloc 104 et du coeur du guide d'onde 36 est obtenue. L'étape 160 de retrait de la couche 152 en nitrure de silicium est alors terminée

Éventuellement, après l"étape 160 et lors d'une étape 169, des opérations de gravure localisée de la face supérieure du guide d'onde 36 sont réalisées. Ces opérations sont, par exemple, mises en oeuvre pour structurer le réflecteur 14 dans le guide d'onde 36.

Pour compenser l'épaisseur de matériau diélectrique consommée lors de l'opération 168 et pour recouvrir les sommets du bloc 104 et du coeur en nitrure de silicium, lors d'une étape 170, la sous-couche 106 de matériau diélectrique est déposée sur la face extérieure. Ici, le matériau diélectrique déposé lors de l'étape 170 est de l'oxyde de silicium. On obtient alors l'état représenté sur la figure 19.

Éventuellement, l'étape 170 est suivie d'une étape 172 de planarisation de la sous-couche 106.

Par exemple, à l'issue de l'étape 170, l'épaisseur de la sous-couche 106 est égale à 20 nm.

La phase 118 de fabrication de la couche mixte 66 est alors terminée.

Ensuite, lors d'une étape 176, une vignette ou un substrat en matériau à gain III-V est directement collée sur la couche mixte 66. Cette vignette ou ce substrat comprend, par exemple, :
- la sous-couche inférieure 70,
- l'empilement de sous-couches en alternance de puits et de barrières en matériaux ternaires et/ou quaternaires, et
- la sous-couche supérieure dopée.

Lors d'une étape 178, la vignette ou le substrat est structuré par gravure pour former le coeur du guide d'onde 28. Typiquement, au cours d'une première gravure, les sous-couches supérieures de la vignette sont gravées pour structurer l'amplificateur 30. Ensuite, lors d'une deuxième gravure, la sous-couche 70 est gravée pour finaliser la structuration de l'amplificateur 30. Lors de l'étape 178, la résistance 80 est également fabriquée.

Enfin, lors d'une étape 180, l'enveloppe 90 et les prises 74, 76, 82 et 84 sont réalisées. La couche 68 en matériau III-V encapsulé est alors obtenue et la fabrication de la source laser 10 est terminée.

La figure 27 représente un deuxième procédé de fabrication de la couche mixte 66 susceptible d'être mis en oeuvre à la place de la phase 118. Ce deuxième procédé est identique à la phase 118 de la figure 11, sauf que :
- l'étape 124 est remplacée par une étape 200, et
- les étapes 160, 169, 170 et 172 sont remplacées par, respectivement, les étapes 202, 215, 216 et 218.

L'étape 200 est identique à l'étape 124, sauf que l'épaisseur de la sous-couche 126 est supérieure à 20 nm de manière à obtenir une marge de sécurité plus importante lors de l'élimination du revêtement 132. Par exemple, lors de l'étape 200, l'épaisseur de la sous-couche 126 est supérieure à 30 nm ou 40 nm. Ici, l'épaisseur de la sous-couche 126 est égale à 40 nm.

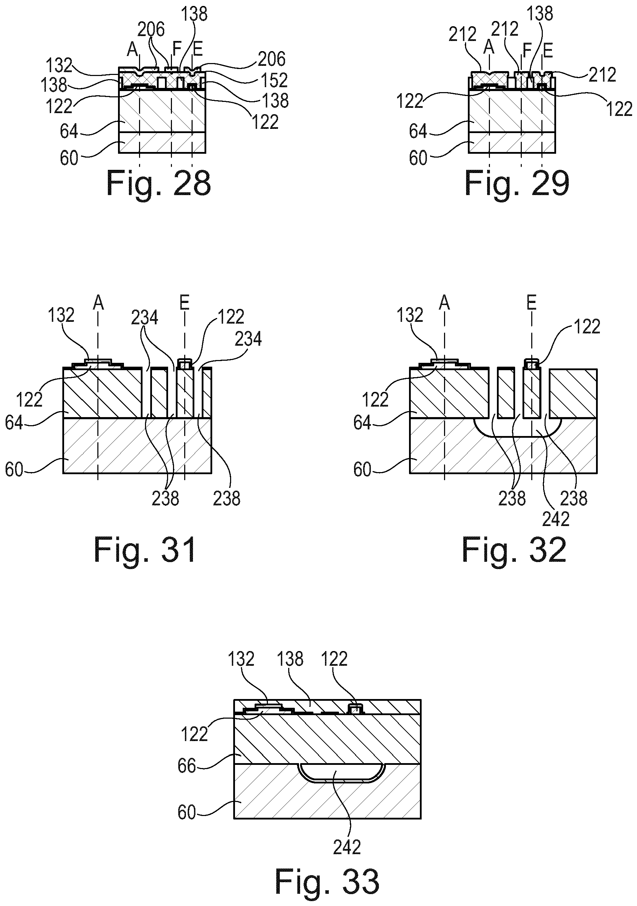

L'étape 202 débute par une opération 204 de formation d'un masque 206 (figure 28) de protection à l'aplomb de la tranchée 146 et de son prolongement 148. Ce masque 206 est conçu pour empêcher la gravure du nitrure de silicium située sous ce masque. Par exemple, le masque 206 est réalisé en résine. On obtient alors l'état représenté sur la figure 28.

Ensuite, une opération 208 de gravure non sélective du nitrure de silicium est exécutée. Cette opération 208 est arrêtée lorsque l'oxyde de silicium situé sous la couche 152 est mis à nu. Par exemple, cette opération est réalisée comme décrit dans le cadre de l'opération 168.

Puis, lors d'une opération 210, le masque 206 est retiré. On obtient alors l'état représenté sur la figure 29. A ce stade, il existe une protubérance 212 en nitrure de silicium au-dessus de la tranchée 146 et de son prolongement 148. Cette protubérance 212 fait saillie au-delà de la face extérieure en oxyde de silicium. Toutefois, la face extérieure est essentiellement en oxyde de silicium, c'est-à-dire que la protubérance 212 recouvre moins de 75% et, typiquement, moins de 50% ou moins de 25% de la face extérieure. Le reste de la face extérieure est en oxyde de silicium.

Lors d'une opération 214, la face extérieure est planarisée en mettant en oeuvre un polissage mécano-chimique pour éliminer la protubérance 212. Par exemple, dans ce mode de réalisation, l'opération 214 est arrêtée lorsque la sous-couche 126 est atteinte. L'opération 214 réduit quand même de 20 nm l'épaisseur de la sous-couche 126. L'étape 202 de retrait de la couche 152 est alors terminée.

Éventuellement, après l'opération 214, une opération 215 identique à l'opération 169 est exécutée.

Ensuite, lors d'une opération 216, la sous-couche 106 est déposée. Cette opération est par exemple identique à l'opération 170.

Enfin, une éventuelle opération 218 de planarisation de la sous-couche 106 est réalisée. L'opération 218 est identique à l'opération 172.

Ici, à l'issue de l'opération 218, l'épaisseur de la sous-couche 106 déposée est supérieure à 50 nm ou 80 nm. Par exemple, l'épaisseur de la sous-couche 106 déposée est égale à 80 nm.

Le procédé de réalisation de la couche mixte 66 est alors terminé.

La figure 30 représente un troisième procédé de fabrication de la couche mixte 66 susceptible d'être mis en oeuvre à la place de la phase 118 dans le procédé de la figure 11. Ce troisième procédé est identique à la phase 118, sauf qu'il comporte, entre les étapes 130 et 136, une étape 230 supplémentaire de réalisation d'une cavité sous le guide d'onde 36.

Plus précisément, lors d'une opération 232, le revêtement 132 est gravé pour former des ouvertures 234 (Figure 31) dans ce revêtement 132. Ces ouvertures 234 s'étendent le long de l'emplacement où doit être réalisé le guide 36. Ici, ces ouvertures 234 s'étendent également le long de l'emplacement où doit être réalisé le bloc 104.

Ensuite, lors d'une opération 236, des tranchées 238 traversant de part en part l'épaisseur de la couche 64 sont réalisées en utilisant le revêtement 132 comme masque de gravure. Ces tranchées 238 débouchent chacune sur le substrat 60. On obtient alors l'état représenté sur la figure 31.

Lors d'une opération 240, une gravure du substrat 60 est réalisée pour former une cavité 242 à l'intérieur du substrat 60. Pour cela, un agent de gravure sélectif est introduit dans les tranchées 238. Cet agent de gravure dissout deux ou quatre fois plus rapidement le silicium que l'oxyde de silicium. De plus, il s'agit ici d'un agent de gravure anisotrope c'est-à-dire un agent de gravure qui dissout le silicium à la même vitesse aussi bien dans la direction verticale que dans la direction horizontale. Ainsi, à l'issue de l'opération 240, la cavité 242 s'étend sous l'emplacement où doivent être réalisés le guide 36 et le bloc 104. Ici, la cavité 242 s'étend aussi sous l'emplacement où doit être réalisé le coupleur 34.

Ensuite, les tranchées 238 sont rebouchées. Par exemple, ici, cela est réalisé lors de l'étape 136. En effet, le dépôt du matériau diélectrique 138 lors de l'étape 136 rebouche les tranchées 238. On obtient alors, à l'issue de l'étape 136, l'état représenté sur la figure 33.

A partir de l'étape 136, le procédé de fabrication de la couche mixte 66 est par exemple identique à ce qui a déjà été décrit en référence à la figure 11 ou 27. Les pointillés sur la figure 30 indiquent que les étapes qui suivent l'étape 136 n'ont pas été représentées.

La cavité 242 permet d'éloigner le guide 36 du substrat 60 et de mieux isoler ce guide 36 du substrat 60. Cette amélioration de l'isolation entre le guide d'onde 36 et le substrat 60 réduit les pertes optiques, notamment lorsque les dimensions transversales du guide 36 sont petites.

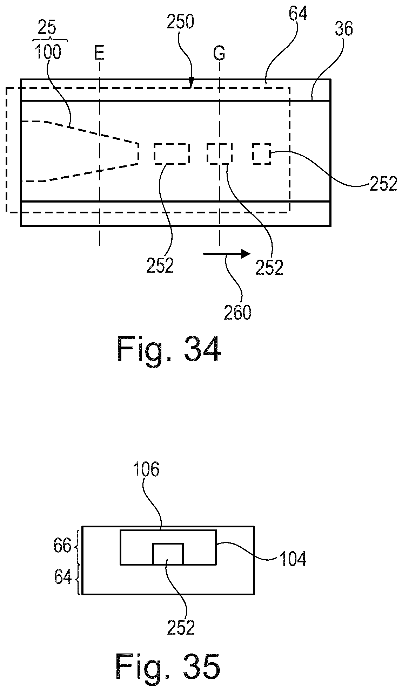

Les figures 34 et 35 représentent un coupleur 250 à pointe inversée susceptible d'être utilisé à la place du coupleur 34. La ligne en pointillés G sur la figure 34 représente l'emplacement de la section transversale G du coupleur 250. La figure 35 représente la section transversale G. Le coupleur 250 est identique au coupleur 34, sauf que la terminaison en pointe de la bande 100 du guide d'onde 25 est remplacée par une terminaison en pointe à motifs sub-longueur d'onde. Dans ce mode de réalisation, au-delà de la terminaison en pointe de la bande 100, le coupleur 250 comporte des motifs 252 alignés les uns derrière les autres dans la direction 260 de propagation du signal optique à la longueur d'onde λ_{Li}. Chaque motif 252 est réalisé en silicium et entièrement encapsulé dans le bloc 104 en nitrure de silicium. Les dimensions horizontales de ces motifs sont inférieures à la longueur d'onde λ_{Li}. De plus, la longueur des motifs 252 dans la direction 260 diminue au fur et à mesure que l'on s'éloigne de la terminaison en pointe. La section transversale de chaque motif 252 est par exemple rectangulaire. Dans ce mode de réalisation, le coupleur 250 comporte trois motifs 252.

### Chapitre III : Variantes :

### Variantes de la source laser :

Le guide d'onde 15 peut être réalisé en silicium.

D'autres modes de réalisation du guide d'onde 25 sont possibles. Par exemple, en variante, l'arête 102 est omise. Dans ce cas, la conformation du guide d'onde 25 est appelée « guide d'onde à bande » (« slab waveguide » en anglais). Dans ce cas, le coupleur 34 comporte une seule terminaison en pointe, c'est-à-dire celle réalisée en rétrécissant la section transversale de la bande 100.

Dans une autre variante, la face supérieure de l'arête 102 affleure la face supérieure du bloc 104.

La gaine du guide d'onde 25 n'est pas nécessairement réalisée en nitrure de silicium. Elle peut aussi être réalisée en oxyde de silicium par exemple. Dans ce cas, le bloc 104 en nitrure de silicium est omis dans la portion du guide 25 située avant le coupleur 34. Le matériau diélectrique situé entre les guides d'onde 28 et 25 ne comporte alors aucune épaisseur de nitrure de silicium.

De nombreuses variantes de la source laser sont possibles. Par exemple, les coupleurs 26 et 32 peuvent être réalisés différemment. Ainsi, à titre d'exemple, la terminaison en pointe peut être réalisée dans le guide 25 et/ou dans le guide 28.

D'autres modes de réalisation des coupleurs 24 et 34 sont possibles. En particulier, ces coupleurs ne sont pas nécessairement réalisés à l'aide d'une transition à pointe inversée. Par exemple, en variante, si la section transversale du guide d'onde 25 est petite, c'est-à-dire typiquement inférieure à 100 nm x 100 nm, alors un couplage optique connu sous le terme anglais de « Butt coupling » peut être mis en oeuvre. Dans ce cas, la gaine du guide d'onde 25 est généralement entièrement réalisée dans un matériau diélectrique différent du nitrure de silicium, tel que de l'oxyde de silicium.

Les différentes variantes d'une source laser à semi-conducteur décrites dans le brevet US10270222B1 et dans la demande WO20190027631 sont applicables à une source laser comportant une couche mixte comme décrite dans cette demande. En particulier, il existe de nombreux autres modes de réalisation possibles pour le filtre 22 et les réflecteurs 12 et 14.

En variante, le filtre 22 est réalisé dans le guide d'onde 25 en silicium.

Jusqu'à présent, la source laser a été décrite dans le cas particulier où il s'agit d'une source laser DBR (« Distributed Bragg Reflector »). Toutefois, une couche mixte telle que la couche mixte 66 peut aussi être utilisée pour réaliser une source laser DFB (« Distributed FeedBack »). Dans ce dernier cas, le guide d'onde en nitrure de silicium se situe aussi dans le prolongement du guide d'onde en silicium réalisé sous le guide d'onde en matériau III-V. Par contre, le réseau de Bragg est réalisé dans le guide d'onde en silicium ou dans une sous-couche en nitrure de silicium interposée entre le guide d'onde en silicium et le guide d'onde en matériau III-V.

### Variantes des procédés de fabrication de la couche mixte :

Lors de l'étape 120, la couche 122 peut aussi être en silicium amorphe.

D'autres modes de réalisation de l'étape 124 de structuration du coeur en silicium sont possibles. Par exemple, la sous-couche 126 d'oxyde de silicium peut être omise.

Lors de l'étape 124, la structuration du coeur en silicium peut aussi comporter des opérations d'accroissement localisé ou par croissance de silicium monocristallin ou par dépôt de silicium amorphe, ou par dépôt de silicium amorphe suivi d'une recristallisation par traitement thermique pour augmenter localement l'épaisseur du coeur en silicium. Dans ce cas, l'épaisseur initiale de la couche 122 en silicium monocristallin peut être réduite. Par exemple, l'épaisseur initiale de la couche 122 est alors de 300 nm.

Lors de l'étape 130, le revêtement 132 d'arrêt de gravure peut être réalisé dans d'autres matériaux que du nitrure de silicium. Par exemple, il peut être réalisé en Al₂O₃ ou en HfO₂. Dans ce cas, la face inférieure du guide 36 est située à un niveau légèrement au-dessus de la face inférieure du guide 25. Typiquement, la différence de hauteur entre ces deux faces inférieures reste cependant inférieure à 100 nm et, généralement, inférieure à 50 nm.

Lors de l'opération 162, un autre matériau que de l'oxyde de silicium peut être utilisé à partir du moment où se matériau peut être planarisé puis gravé comme décrit lors des opérations 166 et 168.

Lors de l'opération 166, le polissage mécano-chimique de la couche en oxyde de silicium peut aussi être arrêté avant d'atteindre la couche 152 en nitrure de silicium. Dans ce cas, il existe, à la fin de cette opération de polissage, une couche résiduelle d'oxyde de silicium qui recouvre complètement la couche 152 en nitrure de silicium. Ensuite, cette couche résiduelle est complètement éliminée lors de l'opération 168 de gravure non sélective.

Dans une autre variante, l'opération 168 de gravure non sélective est poursuivie jusqu'à atteindre le revêtement 132 ou la sous-couche 126. Dans ce cas, au moins une partie ou la totalité du revêtement 132 en nitrure de silicium est aussi éliminée.

Lors de l'opération 170, un autre matériau diélectrique que de l'oxyde de silicium peut être déposé pour former la sous-couche 106. Typiquement, cet autre matériau est alors choisi pour permettre un bon collage directe de la vignette ou du substrat en matériau III-V.

Lors de l'étape 176, au lieu de coller une vignette ou un substrat en matériau à gain III-V, il est possible de déposer ce matériau sur la couche mixte 66.

En variante, l'opération 208 de gravure non-sélective du nitrure de silicium est arrêtée avant d'atteindre la sous-couche 126. Par exemple, elle est arrêtée lorsque la sous-couche 140 est atteinte.

La phase de fabrication d'une couche mixte peut être mise en oeuvre dans d'autres procédés qu'un procédé de fabrication d'une source laser. En particulier, le procédé décrit est aussi adapté à la fabrication d'une couche mixte dans laquelle les guides d'onde en silicium et en nitrure de silicium contenus dans cette couche mixte ne sont pas couplés optiquement l'un à l'autre par un coupleur optique tels que les coupleurs 24 et 34. Par exemple, le couplage optique entre ces deux guides d'onde peut être réalisé à l'aide d'un coupleur optique dont au moins une partie est réalisée dans une couche située au-dessus ou au-dessous de la couche mixte. Les procédés décrits ici permettent aussi de réaliser une couche mixte dans laquelle les guides d'onde en silicium et en nitrure de silicium ne sont pas optiquement couplés l'un à l'autre. Dans ce cas, la réalisation d'un coupleur optique comme les coupleurs 24 et 34 est omise.

Par exemple, le procédé de fabrication d'une couche mixte décrit ici peut être utilisé pour fabriquer une couche mixte d'autres composants photoniques qu'une source laser. Par exemple, ce procédé peut être utilisé pour fabriquer une couche mixte comportant les électrodes d'un modulateur optique. Il peut aussi être utilisé pour fabriquer la couche mixte de tout composant photonique comportant une couche en matériau III-V empilée sur la couche mixte. Par exemple, les procédés décrits ici peuvent être mis en oeuvre lors de la fabrication des composants photoniques suivants : un amplificateur optique à semi-conducteur connu sous l'acronyme SOA (Semiconductor Optical Amplifier), un modulateur à électroabsorption connu sous l'acronyme EAM (Electro-Absorption Modulator), une photodiode. Par exemple, un SOA peut être obtenu à partir du composant photonique de la figure 1 en omettant les réflecteurs 12 et 14 et le filtre 22. Un EAM peut être obtenu à partir du composant de la figure 1 en omettant les réflecteurs 12 et 14, le filtre 22 et en raccourcissant la longueur du composant 30. Les procédés décrits ici pour fabriquer la couche mixte peuvent aussi être mis en oeuvre pour la fabrication des composants photoniques suivants :
- un transmetteur comportant plusieurs sources lasers qui émettent des signaux optiques à différentes longueurs d'onde et un multiplexeur connu sous l'acronyme AWG (Arrayed Waveguide Gratings) réalisé dans le guide d'onde en nitrure de silicium,
- un récepteur comportant plusieurs photodétecteurs et un démultiplexeur AWG réalisé dans le guide d'onde en nitrure de silicium,
- un ensemble de plusieurs amplificateurs optiques à semi-conducteur à large bande raccordés à l'entrée et/ou à la sortie d'un multiplexeur/démultiplexeur AWG qui sépare les signaux optiques amplifiés à différentes longueurs d'onde, le multiplexeur/démultiplexeur AWG étant réalisé dans le guide d'onde en nitrure de silicium,
- des ondemètres ("Wavemeter" en anglais) utilisant le coefficient thermo-optique différent du nitrure de silicium,
- des peignes optiques générés par des corps solides pompés par diode laser.

Les procédés décrits ici pour fabriquer une couche mixte peuvent aussi être mis en oeuvre dans des procédés de fabrication de composants photoniques qui ne comportent pas de couche en matériau III-V encapsulé.

### Autres variantes :

La couche mixte peut comporter des guides d'ondes supplémentaires en silicium ou en nitrure de silicium. Par exemple, l'un de ces guides d'onde supplémentaire est optiquement raccordé en sortie du réflecteur 12 ou 14.

Alternativement, en inversant la polarisation du signal d'alimentation entre les prises 74, 76 de l'amplificateur 30, le signal optique entrant est absorbé au lieu d'être amplifié. L'amplificateur 30 est alors utilisé pour faire de la photo-détection ou de la modulation de signaux.

En variante, ces composants photoniques, et en particulier les composants photoniques comportant une couche en matériau III-V empilé sur la couche mixte telle que la source laser 10, peuvent être fabriqués en utilisant un autre procédé de fabrication de la couche mixte 66 que ceux décrits ici. Ainsi, les modes de réalisation de la source laser décrits ici peuvent être mis en oeuvre indépendamment des procédés qui ont été décrits pour fabriquer cette couche mixte.

### Chapitre IV : Avantages des modes de réalisation décrits :

Les procédés de fabrication d'une couche mixte décrits ici sont simples. En effet, ils ne nécessitent aucun retournement du substrat. Dès lors, toutes les étapes de gravure, de planarisation et de dépôt pour réaliser la couche mixte sont réalisées à partir du même côté de ce substrat 60.

Les procédés de fabrication d'une couche mixte décrits ici permettent aussi d'obtenir une densité d'intégration plus importante que les procédés connus. En effet, des procédés connus mettent en oeuvre le report d'une vignette de nitrure de silicium et/ou d'une vignette de silicium monocristallin sur la couche 64. Dans ce dernier cas, un espace de plusieurs centaines de micromètres doit nécessairement exister entre ces vignettes en silicium et en nitrure de silicium. Dès lors, les coeurs en silicium et en nitrure de silicium réalisés en structurant ces vignettes sont nécessairement espacés l'un de l'autre par plusieurs centaines de micromètres.

L'utilisation d'un revêtement d'arrêt permet de positionner précisément le fond de la tranchée 146 à moins de 100 nm de la face supérieure de la couche 64. Ainsi, cela permet finalement d'obtenir un coeur en nitrure de silicium et un coeur en silicium dont les faces inférieures sont situées dans des niveaux espacés l'un de l'autre par une distance inférieure à 100 nm et tous les deux situés à moins de 100 nm de la couche 64.

Lorsque le revêtement 132 est en nitrure de silicium, les faces inférieures des coeurs en silicium et en nitrure de silicium sont situées dans le même plan horizontal.

La réalisation d'un prolongement de la tranchée 146 au-dessus de la ou des terminaisons en pointe du coeur en silicium permet d'obtenir un couplage optique entre les guides d'onde en silicium et en nitrure de silicium entièrement réalisé à l'intérieur de la couche mixte. Il n'est donc pas nécessaire pour réaliser ce couplage d'utiliser une couche supplémentaire située au-dessus ou au-dessous de cette couche mixte.

Le fait de former la gaine du guide 25 en nitrure de silicium permet d'améliorer les propriétés optiques du guide d'onde en silicium.

L'utilisation d'une couche mixte pour fabriquer un composant photonique permet d'augmenter la densité d'intégration de ce composant photonique. En effet, il n'est plus nécessaire d'avoir les guides d'onde en silicium dans une première couche et les guides d'onde en nitrure de silicium dans une seconde couche située au-dessus ou au-dessous de cette première couche.

## Revendications

1. Procédé de fabrication d'une couche mixte contenant un premier guide d'onde dont le coeur est en silicium et un second guide d'onde dont le coeur est en nitrure de silicium, ce procédé comportant les étapes suivantes :
1) la fourniture (120) d'un substrat sur lequel sont empilées dans l'ordre une couche en matériau diélectrique enterré et une couche de silicium, ce substrat s'étendant essentiellement dans un plan appelé « plan du substrat » et les différentes couches s'étendant parallèlement au plan du substrat, puis
2) la structuration (124) de la couche en silicium pour former le coeur en silicium du premier guide d'onde, puis
3) l'encapsulation (136) du coeur en silicium formé dans du matériau diélectrique puis la planarisation du matériau diélectrique, cette encapsulation suivie de cette planarisation formant une couche de silicium encapsulé contenant le coeur en silicium,
**caractérisé en ce que** le procédé comporte ensuite les étapes suivantes :
4) la réalisation (144) d'une tranchée, dans la couche de silicium encapsulé, à l'emplacement où doit être réalisé le coeur en nitrure de silicium du second guide d'onde, puis
5) le dépôt (150) d'une couche de nitrure de silicium sur la couche de silicium encapsulé, cette couche de nitrure de silicium recouvrant complètement la couche de silicium encapsulé et l'épaisseur de la couche de nitrure de silicium déposée étant suffisante pour remplir complètement la tranchée, puis
6) le retrait (160; 202) du nitrure de silicium situé en dehors de la tranchée pour mettre à nu une face supérieure de la couche en silicium encapsulée sur laquelle la tranchée remplie de nitrure de silicium affleure et ainsi obtenir le coeur en nitrure de silicium du second guide d'onde, puis
7) le dépôt (170; 216) d'une couche en matériau diélectrique qui recouvre la face supérieure mise à nue pour finaliser l'encapsulation du coeur en nitrure de silicium et ainsi obtenir la couche mixte contenant à la fois les coeurs en silicium et en nitrure de silicium encapsulés dans du matériau diélectrique.

2. Procédé selon la revendication 1, dans lequel le retrait du nitrure de silicium comporte :
- le dépôt (162) d'une couche en oxyde de silicium sur toute la couche de nitrure de silicium déposée, puis
- le polissage mécano-chimique (166) de cette couche d'oxyde de silicium pour obtenir une face extérieure plus plane que la face extérieure de la couche de nitrure de silicium déposée, puis
- la gravure non sélective (168) de la face extérieure jusqu'à mettre à nu un matériau diélectrique situé sous la couche de nitrure de silicium et ainsi obtenir une face supérieure plane sur laquelle la tranchée remplie de nitrure de silicium affleure, cette gravure non sélective étant réalisée en exposant cette face extérieure à un agent de gravure qui dissout aussi rapidement l'oxyde de silicium que le nitrure de silicium.

3. Procédé selon la revendication 1, dans lequel le retrait du nitrure de silicium comporte :
- la formation (204) d'un masque de protection qui recouvre une zone de la couche en nitrure de silicium située à l'aplomb de la tranchée et qui laisse la majorité de la face extérieure de la couche en nitrure de silicium directement exposée à l'extérieur, puis
- la gravure (208) de la face extérieure de la couche en nitrure de silicium jusqu'à mettre à nu un matériau diélectrique situé sous cette couche de nitrure de silicium, lors de cette gravure, l'agent de gravure utilisé dissout dix fois plus rapidement le nitrure de silicium et que le masque de protection, puis
- le retrait (210) du masque de protection pour obtenir une face extérieure formée par le matériau diélectrique mis à nu et par des protubérances en nitrure de silicium à l'emplacement du masque de protection retiré, puis
- le polissage mécano-chimique (214) de la face extérieure comportant les protubérances en nitrure de silicium pour obtenir la face supérieure de la couche en silicium encapsulé sur laquelle la tranchée remplie de nitrure de silicium affleure.

4. Procédé selon l'une quelconque des revendications précédentes, dans lequel le procédé comporte, après l'étape 2) et avant l'étape 3) :
- le dépôt (130) sur la couche en matériau diélectrique enterré et à l'emplacement où doit être réalisée la tranchée, d'un revêtement d'arrêt de gravure dont l'épaisseur est inférieure à 100 nm, puis
- lors de l'étape 3), le matériau diélectrique utilisé pour encapsuler le coeur en silicium est différent du matériau utilisé pour former le revêtement d'arrêt de gravure, et
- l'étape 4) comporte :
- la réalisation de la tranchée par gravure à travers un masque qui expose seulement la face supérieure de la couche de silicium encapsulé à l'emplacement où droit être réalisée cette tranchée, l'agent de gravure utilisé dissolvant au moins deux fois plus rapidement le matériau diélectrique utilisé pour encapsuler le coeur en silicium que le matériau utilisé pour réaliser le revêtement d'arrêt de gravure, puis
- l'arrêt de cette gravure lorsque le revêtement d'arrêt est atteint.

5. Procédé selon la revendication 4, dans lequel le revêtement d'arrêt de gravure est réalisé en nitrure de silicium.

6. Procédé selon l'une quelconque des revendications précédentes, dans lequel :
- l'étape 2) comporte la structuration (124) du coeur en silicium monocristallin avec des flancs latéraux qui, au niveau d'une extrémité de ce coeur en silicium monocristallin, se rapprochent l'un de l'autre pour former une terminaison en pointe au-delà de laquelle le signal optique ne se propage plus à l'intérieur du guide d'onde en silicium,
- l'étape 4) comporte la réalisation (144) d'un prolongement de la tranchée, ce prolongement mettant à nu les flancs latéraux du coeur en silicium au moins au niveau de sa terminaison en pointe, et
- lors de l'étape 5), le dépôt (150) de la couche de nitrure de silicium forme également un bloc en nitrure de silicium qui recouvre les flancs latéraux mis à nu du coeur en silicium.

7. Procédé selon la revendication 6, dans lequel :
- lors de l'étape 4), la réalisation (144) du prolongement de la tranchée met à nu les flancs latéraux du coeur en silicium sur toute la longueur du coeur en silicium, et
- lors de l'étape 5), le dépôt (150) de la couche de nitrure de silicium forme un bloc en nitrure de silicium qui recouvre entièrement l'ensemble des flancs latéraux du coeur en silicium, ce bloc en nitrure de silicium formant ainsi une portion de la gaine du guide d'onde en silicium.

8. Procédé de fabrication d'un composant photonique à semi-conducteur III-V, ce procédé comportant :
- la fabrication (118) d'une couche mixte conformément à l'une quelconque des revendications précédentes, contenant un premier guide d'onde dont le coeur est en silicium et un second guide d'onde dont le coeur est en nitrure de silicium, puis
- la réalisation (176) d'une épaisseur de matériau III-V directement sur la couche mixte fabriquée, puis
- la structuration (178) de l'épaisseur de matériau III-V pour former le coeur d'un troisième guide d'onde en matériau III-V, puis
- l'encapsulation (180) dans un matériau diélectrique du coeur du troisième guide d'onde pour former la gaine de ce troisième guide d'onde, et
- la réalisation (124, 178) d'un couplage adiabatique entre le troisième guide d'onde et le premier guide d'onde.

9. Composant photonique à semi-conducteur III-V fabriqué par le procédé de la revendication 8, **caractérisé en ce que** ce composant photonique comporte :
- un substrat (60) sur lequel sont empilées, dans l'ordre :
- une couche mixte (66) contenant un premier guide d'onde (25) dont le coeur est en silicium et un second guide d'onde (36) dont le coeur est en nitrure de silicium, et
- une couche (68) en matériau III-V encapsulé contenant le coeur d'un troisième guide d'onde (28) en matériau III-V,
ce substrat s'étendant essentiellement dans un plan appelé « plan du substrat » et les différentes couches s'étendant parallèlement au plan du substrat, et
- un couplage adiabatique (26, 32) entre le troisième guide d'onde et le premier guide d'onde.

10. Composant photonique selon la revendication 9, dans lequel :
- le coeur du premier guide d'onde comporte des premier et second flancs latéraux (100g, 100d, 102g, 102d) qui s'étendent chacun dans une direction perpendiculaire au plan du substrat, et, au niveau d'une extrémité du premier guide d'onde, les flancs latéraux se rapprochent l'un de l'autre pour former une terminaison en pointe au-delà de laquelle le signal optique ne se propage plus à l'intérieur du premier guide d'onde mais à l'intérieur du deuxième guide d'onde,
- la portion de la gaine du premier guide d'onde (25) qui recouvre les flancs latéraux du coeur en silicium sur toute la longueur de la terminaison en pointe, est réalisée en nitrure de silicium,
- le coeur en nitrure de silicium du deuxième guide d'onde (36) est situé à l'intérieur de la couche mixte dans le prolongement de la terminaison en pointe du coeur en silicium, et
- le coeur en nitrure de silicium du deuxième guide d'onde (36) forme un seul bloc de matière avec la portion de la gaine du premier guide d'onde qui recouvre les flancs latéraux de la terminaison en pointe du coeur en silicium pour coupler optiquement ce deuxième guide d'onde au premier guide d'onde.

11. Composant photonique selon la revendication 10, dans lequel le composant photonique est une source laser apte à émettre un signal optique à au moins une longueur d'onde λ_{Li}, cette source laser comportant une cavité optique apte à faire résonner le signal optique à la longueur d'onde λ_{Li}, cette cavité optique comportant :
- le troisième guide d'onde (28), le coeur de ce troisième guide d'onde étant réalisé en matériau à gain III-V pour amplifier le signal optique à la longueur d'onde λ_{Li} qui se propage le long du coeur de ce troisième guide d'onde, ce troisième guide d'onde étant situé à l'intérieur de la couche de matériau III-V encapsulé,
- le premier guide d'onde (25) dont le coeur est réalisé en silicium,
- le deuxième guide d'onde (36) dont le coeur est réalisé en nitrure de silicium.

## Patentansprüche

1. Verfahren zur Herstellung einer gemischten Schicht, die einen ersten Wellenleiter, dessen Kern aus Silicium ist, und einen zweiten Wellenleiter, dessen Kern aus Siliciumnitrid ist, enthält, wobei das Verfahren die folgenden Schritte umfasst:
1) das Bereitstellen (120) eines Substrats, auf dem in der Reihenfolge eine Schicht aus vergrabenem dielektrischem Material und eine Schicht aus Silicium gestapelt sind, wobei sich dieses Substrat im Wesentlichen in einer Ebene, "Ebene des Substrats" genannt, erstreckt und sich die verschiedenen Schichten parallel zu der Ebene des Substrats erstrecken, dann
2) das Strukturieren (124) der Schicht aus Silicium, um den Kern aus Silicium des ersten Wellenleiters zu bilden, dann
3) das Kapseln (136) des gebildeten Kerns aus Silicium in dielektrisches Material, dann das Planarisieren des dielektrischen Materials, wobei dieses Kapseln und das anschließende Planarisieren eine Schicht aus gekapseltem Silicium bilden, die den Kern aus Silicium enthält,
**dadurch gekennzeichnet, dass** das Verfahren anschließend die folgenden Schritte umfasst:
4) das Ausführen (144) eines Grabens in der Schicht aus gekapseltem Silicium an der Stelle, an welcher der Kern aus Siliciumnitrid des zweiten Wellenleiters ausgeführt werden soll, dann
5) das Abscheiden (150) einer Siliciumnitridschicht auf der Schicht aus gekapseltem Silicium, wobei diese Siliciumnitridschicht die Schicht aus gekapseltem Silicium vollständig bedeckt und wobei die Dicke der abgeschiedenen Siliciumnitridschicht ausreichend ist, um den Graben vollständig zu füllen, dann
6) das Abtragen (160; 202) des außerhalb des Grabens gelegenen Siliciumnitrids, um eine Oberseite der gekapselten Schicht aus Silicium freizulegen, mit welcher der mit Siliciumnitrid gefüllte Graben bündig ist, und so den Kern aus Siliciumnitrid des zweiten Wellenleiters zu erhalten, dann
7) das Abscheiden (170; 216) einer Schicht aus dielektrischem Material, welche die freigelegte Oberseite bedeckt, um das Kapseln des Kerns aus Siliciumnitrid abzuschließen und so die gemischte Schicht zu erhalten, die gleichzeitig die Kerne aus Silicium und aus Siliciumnitrid enthält, die in dielektrisches Material gekapselt sind.

2. Verfahren nach Anspruch 1, wobei das Abtragen des Siliciumnitrids umfasst:
- das Abscheiden (162) einer Schicht aus Siliciumoxid auf der gesamten abgeschiedenen Siliciumnitridschicht, dann
- das chemisch-mechanische Polieren (166) dieser Siliciumoxidschicht, um eine Außenseite zu erhalten, die ebener als die Außenseite der abgeschiedenen Siliciumnitridschicht ist, dann
- das nicht selektive Ätzen (168) der Außenseite, bis ein dielektrisches Material freigelegt wird, das unter der Siliciumnitridschicht gelegen ist, und so eine ebene Oberseite erhalten wird, mit welcher der mit Siliciumnitrid gefüllte Graben bündig ist, wobei dieses nicht selektive Ätzen ausgeführt wird, indem diese Außenseite einem Ätzmittel ausgesetzt wird, welches das Siliciumoxid ebenso schnell löst wie das Siliciumnitrid.

3. Verfahren nach Anspruch 1, wobei das Abtragen des Siliciumnitrids umfasst:
- das Bilden (204) einer Schutzmaske, die einen Bereich der Schicht aus Siliciumnitrid bedeckt, der in der Lotrechten über dem Graben gelegen ist, und den überwiegenden Teil der Außenseite der Schicht aus Siliciumnitrid frei lässt, die direkt der Außenumgebung ausgesetzt ist, dann
- das Ätzen (208) der Außenseite der Schicht aus Siliciumnitrid, bis ein dielektrisches Material freigelegt wird, das unter dieser Siliciumnitridschicht gelegen ist, wobei bei diesem Ätzen das verwendete Ätzmittel das Siliciumnitrid zehn Mal schneller löst als die Schutzmaske, dann
- das Abtragen (210) der Schutzmaske, um eine Außenseite zu erhalten, die aus dem freigelegten dielektrischen Material und aus Höckern aus Siliciumnitrid an der Stelle der abgetragenen Schutzmaske gebildet wird, dann
- das chemisch-mechanische Polieren (214) der Außenseite, welche die Höcker aus Siliciumnitrid umfasst, um die Oberseite der Schicht aus gekapseltem Silicium zu erhalten, mit welcher der mit Siliciumnitrid gefüllte Graben bündig ist.

4. Verfahren nach einem der vorhergehenden Ansprüche, wobei das Verfahren nach dem Schritt 2) und vor dem Schritt 3) umfasst:
- das Abscheiden (130), auf der Schicht aus vergrabenem dielektrischem Material und an der Stelle, an welcher der Graben ausgeführt werden soll, einer Ätzstopp-Beschichtung, deren Dicke weniger als 100 nm beträgt, dann
- beim Schritt 3) das zum Kapseln des Kerns aus Silicium verwendete dielektrische Material verschieden von dem zum Bilden der Ätzstopp-Beschichtung verwendeten Material ist und
- der Schritt 4) umfasst:
- das Ausführen des Grabens durch Ätzen durch eine Maske hindurch, die nur die Oberseite der Schicht aus gekapseltem Silicium an der Stelle aussetzt, an der dieser Graben ausgeführt werden soll, wobei das verwendete Ätzmittel das zum Kapseln des Kerns aus Silicium verwendete dielektrische Material mindestens zwei Mal schneller löst als das zum Ausführen der Ätzstopp-Beschichtung verwendete Material, dann
- das Stoppen dieses Ätzens, wenn die Stopp-Beschichtung erreicht ist.

5. Verfahren nach Anspruch 4, wobei die Ätzstopp-Beschichtung aus Siliciumnitrid ausgeführt ist.

6. Verfahren nach einem der vorhergehenden Ansprüche, wobei:
- der Schritt 2) das Strukturieren (124) des Kerns aus monokristallinem Silicium mit seitlichen Flanken umfasst, die sich an einem Ende dieses Kerns aus monokristallinem Silicium einander annähern, um eine Zuspitzung zu bilden, jenseits der das optische Signal sich nicht mehr im Inneren des Wellenleiters aus Silicium ausbreitet,
- der Schritt 4) das Ausführen (144) einer Verlängerung des Grabens umfasst, wobei diese Verlängerung die seitlichen Flanken des Kerns aus Silicium mindestens an seiner Zuspitzung freilegt, und
- beim Schritt 5) das Abscheiden (150) der Siliciumnitridschicht auch einen Block aus Siliciumnitrid bildet, der die freigelegten seitlichen Flanken des Kerns aus Silicium bedeckt.

7. Verfahren nach Anspruch 6, wobei:
- beim Schritt 4) das Ausführen (144) der Verlängerung des Grabens die seitlichen Flanken des Kerns aus Silicium über die gesamte Länge des Kerns aus Silicium freilegt und
- beim Schritt 5) das Abscheiden (150) der Siliciumnitridschicht einen Block aus Siliciumnitrid bildet, der die Gesamtheit der seitlichen Flanken des Kerns aus Silicium vollständig bedeckt, wobei dieser Block aus Siliciumnitrid somit einen Abschnitt des Mantels des Wellenleiters aus Silicium bildet.

8. Verfahren zur Herstellung eines photonischen III-V-Halbleiter-Bauelements, wobei dieses Verfahren umfasst:
- das Herstellen (118) einer gemischten Schicht gemäß einem der vorhergehenden Ansprüche, die einen ersten Wellenleiter, dessen Kern aus Silicium ist, und einen zweiten Wellenleiter, dessen Kern aus Siliciumnitrid ist, enthält, dann
- das Ausführen (176) einer Dicke aus III-V-Material direkt auf der hergestellten gemischten Schicht, dann
- das Strukturieren (178) der Dicke aus III-V-Material, um den Kern eines dritten Wellenleiters aus III-V-Material zu bilden, dann
- das Kapseln (180) des Kerns des dritten Wellenleiters in ein dielektrisches Material, um den Mantel dieses dritten Wellenleiters zu bilden, und
- das Ausführen (124, 178) einer adiabatischen Kopplung zwischen dem dritten Wellenleiter und dem ersten Wellenleiter.

9. Photonisches III-V-Halbleiter-Bauelement, das nach dem Verfahren des Anspruchs 8 hergestellt wird, **dadurch gekennzeichnet, dass** dieses photonische Bauelement umfasst:
- ein Substrat (60), auf dem in der Reihenfolge gestapelt sind:
- eine gemischte Schicht (66), die einen ersten Wellenleiter (25), dessen Kern aus Silicium ist, und einen zweiten Wellenleiter (36), dessen Kern aus Siliciumnitrid ist, enthält, und
- eine Schicht (68) aus gekapseltem III-V-Material, die den Kern eines dritten Wellenleiters (28) aus III-V-Material enthält, wobei sich dieses Substrat im Wesentlichen in einer Ebene, "Ebene des Substrats" genannt, erstreckt und sich die verschiedenen Schichten parallel zu der Ebene des Substrats erstrecken, und
- eine adiabatische Kopplung (26, 32) zwischen dem dritten Wellenleiter und dem ersten Wellenleiter.

10. Photonisches Bauelement nach Anspruch 9, wobei:
- der Kern des ersten Wellenleiters erste und zweite seitliche Flanken (100g, 100d, 102g, 102d) umfasst, die sich jeweils in einer senkrecht zur Ebene des Substrats verlaufenden Richtung erstrecken, und die seitlichen Flanke sich an einem Ende des ersten Wellenleiters einander nähern, um eine Zuspitzung zu bilden, jenseits der sich das optische Signal nicht mehr im Inneren des ersten Wellenleiters, sondern im Inneren des zweiten Wellenleiters ausbreiten,
- der Abschnitt des Mantels des ersten Wellenleiters (25), der die seitlichen Flanken des Kerns aus Silicium über die gesamte Länge der Zuspitzung bedeckt, aus Siliciumnitrid ausgeführt ist,
- der Kern aus Siliciumnitrid des zweiten Wellenleiters (36) im Inneren der gemischten Schicht in der Verlängerung der Zuspitzung des Kerns aus Silicium gelegen ist und
- der Kern aus Siliciumnitrid des zweiten Wellenleiters (36) einen einzigen Materialblock mit dem Abschnitt des Mantels des ersten Wellenleiters bildet, der die seitlichen Flanken der Zuspitzung des Kerns aus Silicium bedeckt, um diesen zweiten Wellenleiter optisch mit dem ersten Wellenleiter zu koppeln.

11. Photonisches Bauelement nach Anspruch 10, wobei das photonische Bauelement eine Laserquelle ist, die geeignet ist, ein optisches Signal mit mindestens einer Wellenlänge λ_{Li} auszusenden, wobei diese Laserquelle einen optischen Hohlraum umfasst, der geeignet ist, das optische Signal mit der Wellenlänge λ_{Li} resonieren zu lassen, wobei dieser optische Hohlraum umfasst:
- den dritten Wellenleiter (28), wobei der Kern dieses dritten Wellenleiters aus III-V-Verstärkungsmaterial ausgeführt ist, um das optische Signal mit der Wellenlänge λ_{Li} zu verstärken, das sich entlang des Kerns dieses dritten Wellenleiters ausbreitet, wobei dieser dritte Wellenleiter im Inneren der Schicht aus gekapseltem III-V-Material gelegen ist,
- den ersten Wellenleiter (25), dessen Kern aus Silicium ausgeführt ist,
- den zweiten Wellenleiter (36), dessen Kern aus Siliciumnitrid ausgeführt ist.

## Claims

1. Process for fabricating a mixed layer containing a first waveguide the core of which is made of silicon and a second waveguide the core of which is made of silicon nitride, this process comprising the following steps:
1) providing (120) a substrate on which are stacked, in order, a buried dielectric layer and a silicon layer, this substrate lying essentially in a plane called the "plane of the substrate" and the various layers lying parallel to the plane of the substrate, then
2) structuring (124) the silicon layer to form the silicon core of the first waveguide, then
3) encapsulating (136) the formed silicon core in dielectric then planarizing the dielectric, this encapsulating step followed by this planarizing step forming an encapsulated-silicon layer containing the silicon core,
**characterized in that** the process then comprises the following steps:
4) producing (144) a trench, in the encapsulated-silicon layer, in the location where the silicon-nitride core of the second waveguide must be produced, then
5) depositing (150) a silicon-nitride layer on the encapsulated-silicon layer, this silicon-nitride layer completely covering the encapsulated-silicon layer and the thickness of the deposited silicon-nitride layer being sufficient to completely fill the trench, then
6) removing (160; 202) the silicon nitride situated outside of the trench to uncover an upper face of the encapsulated-silicon layer, with which the trench filled with silicon nitride is flush and thus to obtain the silicon-nitride core of the second waveguide, then
7) depositing (170; 216) a dielectric layer that covers the uncovered upper face in order to finalise the encapsulation of the silicon-nitride core and thus to obtain the mixed layer containing both the silicon and silicon-nitride cores encapsulated in dielectric.

2. Process according to Claim 1, wherein the step of removing the silicon nitride comprises:
- depositing (162) a silicon-oxide layer on all of the deposited silicon-nitride layer, then
- carrying out chemical-mechanical polishing (166) on this silicon-oxide layer in order to obtain an exterior face that is more planar than the exterior face of the deposited silicon-nitride layer, then
- non-selectively etching (168) the exterior face until a dielectric situated under the silicon-nitride layer is uncovered, thus obtaining a planar upper face with which the trench filled with silicon nitride is flush, this step of etching non-selectively being carried out by exposing this exterior face to an etchant that dissolves silicon oxide as rapidly as silicon nitride.

3. Process according to Claim 1, wherein the step of removing the silicon nitride comprises:
- forming (204) a protective mask that covers a region of the silicon-nitride layer situated plumb with the trench and that leaves most of the exterior face of the silicon-nitride layer directly exposed to the exterior, then
- etching (208) the exterior face of the silicon-nitride layer until a dielectric situated under this silicon-nitride layer is uncovered, the etchant used, in this etching step, dissolving silicon nitride ten times more rapidly than the protective mask, then
- removing (210) the protective mask to obtain an exterior face formed by the uncovered dielectric and by silicon-nitride protuberances in the location of the removed protective mask, then
- carrying out chemical-mechanical polishing (214) on the exterior face comprising the silicon-nitride protuberances to obtain the upper face of the encapsulated-silicon layer with which the trench filled with silicon nitride is flush.

4. Process according to any one of the preceding claims, wherein the process comprises, after step 2) and before step 3):
- depositing (130) on the buried dielectric layer and in the location in which the trench must be produced an etch-stop liner the thickness of which is smaller than 100 nm, then
- in step 3), the dielectric used to encapsulate the silicon core is different from the material used to form the etch-stop liner, and
- step 4) comprises:
- producing the trench by etching through a mask that only exposes the upper face of the encapsulated-silicon layer in the location where this trench must be produced, the etchant used dissolving the dielectric used to encapsulate the silicon core at least two times more rapidly than the material used to produce the etch-stop liner, then
- stopping this etching when the stop liner is reached.

5. Process according to Claim 4, wherein the etch-stop liner is made of silicon nitride.

6. Process according to any one of the preceding claims, wherein:
- step 2) comprises structuring (124) the single-crystal silicon core with sidewalls that, at one end of this single-crystal silicon core, get closer to each other so as to form a tapered termination beyond which the optical signal no longer propagates inside the silicon waveguide,
- step 4) comprises producing (144) an extension of the trench, this extension uncovering the sidewalls of the silicon core at least at its tapered termination, and
- in step 5), depositing (150) the silicon-nitride layer also forms a silicon-nitride block that covers the exposed sidewalls of the silicon core.

7. Process according to Claim 6, wherein:
- in step 4), producing (144) the extension of the trench uncovers the sidewalls of the silicon core over the entire length of the silicon core, and
- in step 5), depositing (150) the silicon-nitride layer forms a silicon-nitride block that entirely covers the entirety of the sidewalls of the silicon core, this silicon-nitride block thus forming a segment of the cladding of the silicon waveguide.

8. Process for fabricating a photonic, III-V semiconductor component, this process comprising:
- fabricating (118) a mixed layer according to anyone of the preceding claims, containing a first waveguide the core of which is made of silicon and a second waveguide the core of which is made of silicon nitride, then
- producing (176) a thickness of III-V material directly on the fabricated mixed layer, then
- structuring (178) the thickness of III-V material to form the core of a third waveguide made of III-V material, then
- encapsulating (180) in a dielectric the core of the third waveguide to form the cladding of this third waveguide, and
- achieving (124, 178) adiabatic coupling between the third waveguide and the first waveguide.

9. Photonic, III-V semiconductor component fabricated using the process of Claim 8, **characterized in that** this photonic component comprises:
- a substrate (60) on which are stacked, in order:
- a mixed layer (66) containing a first waveguide (25) the core of which is made of silicon and a second waveguide (36) the core of which is made of silicon nitride, and
- a layer (68) made of encapsulated III-V material containing the core of a third waveguide (28) made of III-V material,
this substrate lying essentially in a plane called the "plane of the substrate" and the various layers lying parallel to the plane of the substrate, and
- adiabatic coupling (26, 32) between the third waveguide and the first waveguide.

10. Photonic component according to Claim 9, wherein:
- the core of the first waveguide comprises first and second sidewalls (100g, 100d, 102g, 102d) that each extend in a direction perpendicular to the plane of the substrate, and, at an end of the first waveguide, the sidewalls get closer to each other to form a tapered termination beyond which the optical signal no longer propagates inside the first waveguide but rather inside the second waveguide,
- the segment of the cladding of the first waveguide (25) that covers the sidewalls of the silicon core over the entire length of the tapered termination is made of silicon nitride,
- the silicon-nitride core of the second waveguide (36) is situated inside the mixed layer in the extension of the tapered termination of the silicon core, and
- the silicon-nitride core of the second waveguide (36) forms a single block of material with the segment of the cladding of the first waveguide that covers the sidewalls of the tapered termination of the silicon core in order to optically couple this second waveguide to the first waveguide.

11. Photonic component according to Claim 10, wherein the photonic component is a laser source able to emit an optical signal at at least one wavelength λ_{Li}, this laser source comprising an optical cavity able to make the optical signal resonate at the wavelength λ_{Li}, this optical cavity comprising:
- the third waveguide (28), the core of this third waveguide being made of III-V gain material in order to amplify the optical signal at the wavelength λ_{Li} that propagates along the core of this third waveguide, this third waveguide being situated inside the layer of encapsulated III-V material,
- the first waveguide (25) the core of which is made of silicon,
- the second waveguide (36) the core of which is made of silicon nitride.
